# EUROPEAN PATENT APPLICATION

(11) **EP 4 428 890 A1**
(43) Date of publication of application: **11.09.2024**
(21) Application number: 24158144.6
(22) Date of filing: 16.02.2024
(51) Int. Cl.: H01H 9/44, H01H 36/00, H01H 50/54, H01H 9/16, H01H 1/00, H01H 50/08

(54) **ASSEMBLY AND METHOD FOR MONITORING THE STATUS OF A SWITCH FOR HIGH CURRENTS AND/OR HIGH VOLTAGES**

(30) Priority: 21.02.2023 DE 102023104181
(71) Applicant: TE Connectivity Solutions GmbH, 8200 Schaffhausen (CH)
(72) Inventor: WEIGEL, Christfried, 8200 Schaffhausen (CH)
(74) Representative: Grünecker Patent- und Rechtsanwälte PartG mbB

(57) **Abstract**

The invention relates to an assembly (100) for monitoring the status of a switch (200) for high currents and/or high voltages with a blow magnetic field (20) and a control element (40) that can be moved into several control positions (41) by a drive (70), wherein different switching positions (51) of the switch (200) are associated with different control positions (41), wherein the assembly (100) comprises a status sensor (80) that can be influenced by the blow magnetic field (20), and an influencing element (60) for influencing the blow magnetic field (20) at the status sensor (80), wherein the blow magnetic field (20) at the status sensor (80) depends on the relative position between the status sensor (80) and the influencing element (60), and wherein the assembly (100) is configured such that the relative position changes when the control position (41) of the control element (30) changes. Further, a corresponding method is shown.

## Description

The invention relates to an assembly for monitoring the status of a switch for high currents and/or high voltages. Furthermore, the invention relates to a method for monitoring the status of a switch for high currents and/or high voltages.

Such switches often have a blow magnetic field, by means of which arcs that occur when the contacts are separated are deflected and thus extinguished. It is often important to be able to check the status externally, e.g. whether the switch is open or closed. Previous solutions have used mechanically actuated microswitches in the switching chamber, for example. However, this is relatively complex, also due to the adverse conditions in the switching chamber, such as pressure waves and soot formation.

It is the object of the invention to provide a simple solution with which the status can be reliably monitored.

This problem is solved by an assembly for monitoring the status of a switch for high currents and/or high voltages with a blow magnetic field and a control element that can be moved into several control positions by a drive, wherein different switching positions of the switch are associated with different control positions of the control element, wherein the assembly comprises a status sensor that can be influenced by the blow magnetic field and an influencing element for influencing the blow magnetic field at the status sensor, wherein the blow magnetic field at the status sensor depends on a relative position between the status sensor and the influencing element, and wherein the assembly is configured such that the relative position changes when the control position of the control element changes.

In a corresponding method for monitoring the status of a mechanical switch for high currents and/or high voltages with a blow magnetic field, the blow magnetic field acting on a status sensor is changed by moving a control element.

Advantageously, the already existing blow magnetic field is thus also used for status monitoring here. The magnetic measuring principle is relatively insensitive to disturbances such as soot and pressure waves.

The solution according to the invention can be further improved with the following further developments and configurations, each of which is preferred individually and can be combined with one another as desired.

The status sensor can output various status signals depending on the blow magnetic field acting at its location. This allows the status to be easily determined. In some embodiments, the status signals can have a continuous spectrum. In other configurations, the status signals may be discrete. In particular, a status signal may be that a (status sensor) circuit comprising the status sensor is closed by the status sensor in one case and open in another case. Depending on the application, e.g. an open circuit at the status sensor can then correspond to an open or a closed status of the switch and a closed circuit at the status sensor can correspond to a closed or an open status of the switch.

In one possible embodiment, the influencing element is mechanically coupled to the control element, i.e. a movement of the control element leads to a movement of the influencing element by mechanical transmission means. Mechanical is to be understood here as movement-transmitting, possibly with a translation, a lever or similar means. In such a configuration, the status sensor can be fixed during the movement of the control element. For example, it can be fixedly attached to a housing or a base body.

In another possible embodiment, the status sensor is mechanically coupled to the control element. In this case, the influencing element can be fixed when the control element is moved.

In particular, the control element and the influencing element or the status sensor can be rigidly connected to each other, i.e. immovable relative to each other and/or attached to each other. Attachment elements can be provided for this purpose. In another configuration, the rigid connection can be achieved, for example, by welding, soldering or gluing.

In another embodiment, both the influencing element and the status sensor move when the control element moves. This can, for example, lead to a particularly fast and/or large relative movement when the two elements are moved towards each other.

According to a particularly simple configuration, the control element can be configured as an influencing element. This allows the number of parts in the assembly or in the switch to be kept to a minimum.

In further preferred configurations, the control element and the influencing element can have common parts. For example, already existing attachment elements on the control element can be simultaneously used to attach the influencing element.

Furthermore, the control element can be part of the influencing element or the influencing element can be part of the control element. This can also allow the number of parts to be kept to a minimum.

The same considerations apply to the status sensor. It can also be part of the control element or vice versa, or have parts in common with it.

According to a preferred configuration, the control element can be mechanically coupled to a switching element of the switch. The switching element can have various switching positions that are associated with the switching positions. Switching positions can be one or more open switching positions, in which the circuit is interrupted, or one or more closed switching positions, in which one or more circuits are closed. In these configurations, switching therefore takes place indirectly via the control element, which in turn is driven directly or indirectly by a drive, such as a coil. The control element can be part of the drive. It can also be a part in which the switching element is held with or without pretension, such as a cage or a contact bridge holder.

The drive can be part of the switch. For example, it can be a drive with a coil. The drive can also not be part of the switch. Possible drives can be hydraulic, pneumatic, electric or mechanical, for example. Manual drives are also conceivable.

In one possible embodiment, the control element is part of the circuit to be switched. This allows the construction to be simple. For example, the control element can be the switching element. As a switching element, particularly the element of the switch is to be understood with which a circuit is closed or opened.

The way in which the blow magnetic field is influenced by the influencing element can be different.

In a first configuration, the influencing element can be an attenuating element, i.e. an element that attenuates the strength of the blow magnetic field present at the status sensor or directs it around the status sensor. It can be a magnetic shielding element and, in particular, be configured planarly in order to achieve a large shielding effect with a small volume. It can comprise or consist of a magnetically shielding material, in particular a soft magnetic material.

In particular, the strength of the blow magnetic field at the status sensor can be lower if the influencing element is closer to the status sensor.

In at least one of the control positions, the status sensor can be surrounded by a magnetic shielding that is closed in a ring-shaped or annular manner around the status sensor, wherein the influencing element is part of the shielding. In this case, there is a closed circumferential path around the status sensor. This allows particularly effective attenuation. In order to form the shielding, the influencing element can interact with other parts of the switch, e.g. a housing, a base or a magnetic, electrical or mechanical shielding.

The shielding can extend around the status sensor on all sides or quasi-all sides and cover at least 80 % of a spherical surface or the entire solid angle around the status sensor.

In other control positions, there may be no closed shielding to allow the magnetic field to pass through.

According to a further configuration, the influencing element can be an amplifying element. Such an element can amplify or bundle the blow magnetic field present at the status sensor.

In particular, the strength of the blow magnetic field at the status sensor can be higher if the influencing element is closer to the status sensor.

In order to be able to also reliably determine the status with the usual manufacturing tolerances, a difference in the strength of the blow magnetic field at the status sensor should be at least 5 %, preferably at least 10 %, particularly preferably at least 20 %, especially at least 50 % in the configurations described. Here, one value is therefore outside the range of 0.95-1.05 of the other value (and correspondingly for the other values) at a difference of 5 %. The different blow magnetic field strengths are to be measured in particular when the control element is in a first control position and in a second control position. These can define a first or second switching position, e.g. by coming into contact with stops.

In another possible configuration, the influencing element can be a direction-changing element. Such an element changes the direction of the blow magnetic field present at the status sensor. This can also lead to a change in the signal at the status sensor. A change of at least 5 degrees, preferably at least 10 degrees, more preferably at least 45 degrees, in particular at least 90 degrees, can serve as a lower limit for a difference in order to reliably classify a difference in the signal as relevant.

In particular, combinations of the three principles mentioned are also possible. Thus, e.g. the influencing element can change the direction of the blow magnetic field at the status sensor position as well as increase or decrease the strength prevailing there. In particular, if there are several control positions and/or several status sensors, the influencing element can be used as an attenuating element for one control position or status sensor and as an amplifying element for another control position or status sensor.

In a configuration that is easy to manufacture, the influencing element can comprise or be a punched and/or formed, in particular a bent metal sheet.

In order to keep the assembly compact, the influencing element can comprise a channel or a receptacle for the status sensor. It can have a U-shaped cross-section or a trough-shaped configuration into which the status sensor fits with as little clearance as possible, but in compliance with the usual tolerances.

Manufacturing can be simple if the influencing element is symmetrical. For example, the influencing element can have a two-figure or higher rotational symmetry. This allows a step in which the influencing element is correctly oriented during assembly to be omitted. Manufacturing can also be simple with translational symmetry. For example, the influencing element can have a continuous translational symmetry if it is cut from a longer piece with a constant cross-section, such as a U-profile. Manufacturing by extrusion can also lead to such a translational symmetry.

Preferably, the influencing element is one-piece or monolithic. This can minimize the number of elements in the assembly.

The influencing element can be a mechanical shielding for the status sensor. The mechanical shielding can mechanically shield the status sensor at least in one control position. For example, this allows the status sensor to be protected from a pressure wave or soot. In particular, mechanical shielding can be achieved with respect to the control element, the switching element or a contact element. Mechanical shielding can be understood to mean that there is no straight-line connection between two elements.

The control element and/or the switching element can be moved linearly in order to achieve a simple switching movement. During this movement, the control element and/or the switching element can be guided, for example on guiding elements. In other configurations, a rotational movement or a mixture of the two may be possible.

In a preferred configuration, the status sensor is a discrete status sensor. This can have two or more clearly separated output signals.

In particular, the status sensor can comprise a switch. Such a switch can assume two or more sensor switching states. In the first switching position, the blow magnetic field acting at the location of the status sensor can be below and in the second switching position above a switching threshold of the status sensor.

Depending on the application, a switching point of the status sensor can be positioned so that the status sensor switches before or after the switch or relay opens and/or before or after it closes.

In a particularly preferred, very simple configuration, the status sensor consists of a single component.

In particular, the status sensor can be a reed switch. Such a switch can be particularly easy to manufacture and robust. However, other magnetic switches can also be used.

An enlargement of the construction volume can be avoided if the status sensor is arranged within a switching chamber. In particular, the switching chamber can be sealed, as is often the case in high-current and/or high-voltage applications. For example, it can be gas or liquid-tight. At least one switching element, fixed and/or mobile contact elements and/or the blow magnetic field can also be present in the switching chamber.

Connection elements of the status sensor can be accessible from outside the switching chamber. They can be used to connect external elements and include sockets, pins or conductive areas, for example. It is preferred if they are accessible on the outside of the switch, in particular a housing. Accordingly, signal conductors can run from inside the switching chamber to the outside.

The status sensor can have two electrical connections, wherein in a preferred embodiment one of the two electrical connections is connected to an earth or ground potential of the switch. This allows the structure to be kept compact. In particular, this can be an earth or ground potential of a load circuit, a switching circuit, a housing or a shielding.

In order to keep wear to a minimum, the influencing element can influence the status sensor exclusively without contact. In particular, there can be no mechanical contact during switching and/or relative movement.

In a preferred configuration, the blowing effect of the blow magnetic field is not or hardly influenced by the influencing element. This can be regarded as fulfilled if the magnetic field strength at the contacts is reduced by a maximum of 10 %, preferably by a maximum of 5 %, during the initial opening step compared to the case where no influencing element is present. In the case of a direction-changing element, the direction can accordingly be changed by less than 5 degrees. With such solutions, existing systems can be converted with no or few additional changes.

If the contacts of the switch are further apart and the arc has already been extinguished, the blowing effect is no longer relevant. In this state, the blow magnetic field can thus be used for status detection. The blow magnetic field can be influenced by the influencing element to a greater extent. For example, the blow magnetic field between the contacts can only be influenced from a defined release distance between the contacts.

The status sensor can be embedded in a magnetically permeable material in order to hold it and, if necessary, protect it mechanically. This can be the material of a base body of the switch, in particular plastic.

Advantageously, the assembly can be magnet-free, i.e. that particularly in the influencing element no permanent magnet is present. The switch thus only has the magnets that are usually already present for the blow magnetic field.

According to the invention, there is also provided a mechanical switch for high currents and/or high voltages, in particular a relay, comprising a control element and an assembly according to the invention. The switch may have a blow magnet arrangement comprising a magnet and/or magnetic conducting elements. Additional (permanent) magnets can be dispensed with.

In the following, the invention is explained in more detail by means of preferred configurations with reference to the drawings. The preferred further developments and configurations shown here are each independent of one another and can be combined with one another as desired, depending on how this is necessary in the application.

In the figures:
- Fig. 1: shows a schematic sectional view of a first embodiment of a switch with a first embodiment of an assembly for monitoring the status of the switch with two differently oriented influencing elements and corresponding status sensors;
- Fig. 2: shows a schematic sectional view of a first detail of the assembly from Fig. 1;
- Fig. 3: shows a schematic sectional view of a second detail of the assembly from Fig. 1; and
- Fig. 4: shows a schematic exploded view of some parts of a second embodiment of an assembly.

In the figures, two different embodiments of assemblies 100 for monitoring the status of a switch 200 are shown. The switches 200, in this case relays 201, are used to switch high currents and/or high voltages.

For this purpose, the switches 200 have fixed contact elements 58 arranged on contact carriers 220, which are part of a load circuit to be switched. By means of a drive 70, movable contact elements 57 can be moved relative to the fixed contact elements 58. The movable contact elements 57 are arranged on a contact bridge 59, which serves as a switching element 50. Depending on the position of the switching element 50, the associated load circuit can be transferred from the open first switching position 51 shown in the Figures to a closed switching position 52 not shown.

The drive 70 comprises, in particular, a coil 71 through which a current used for switching flows. In the event of such a current flow, the resulting magnetic field pulls a first body 75 towards a second body 76 against the spring force of a spring 72. A drive rod 77, which is connected to the first body 75, thereby transmits the movement to a cage 74. In the cage 74, the contact bridge 59 is coupled to the drive rod 77 via a contact spring 73. Due to the contact spring 73, it is ensured that there is a sufficiently high contact force and thus a low electrical resistance between the moving contact elements 57 and the fixed contact elements 58.

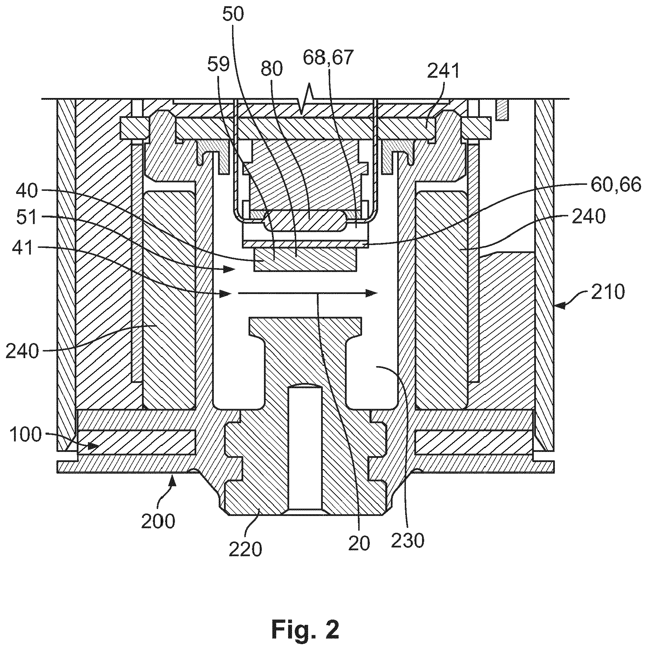

In order to deflect the arcs that occur in particular when separating the contact elements 57, 58 and thereby extinguish them, blow magnets 240 generate a blow magnetic field 20 running through the closed switching chamber 230, which is indicated by magnetic field lines in Fig. 2. In order to close a magnetic circuit, the switch 200 also has magnet conducting elements 241.

In order to be able to monitor the status of the switch 200, in particular to detect whether the connected load circuit is open or closed, an assembly 100 is provided. This uses the existing blow magnetic field 20 of the switch 200.

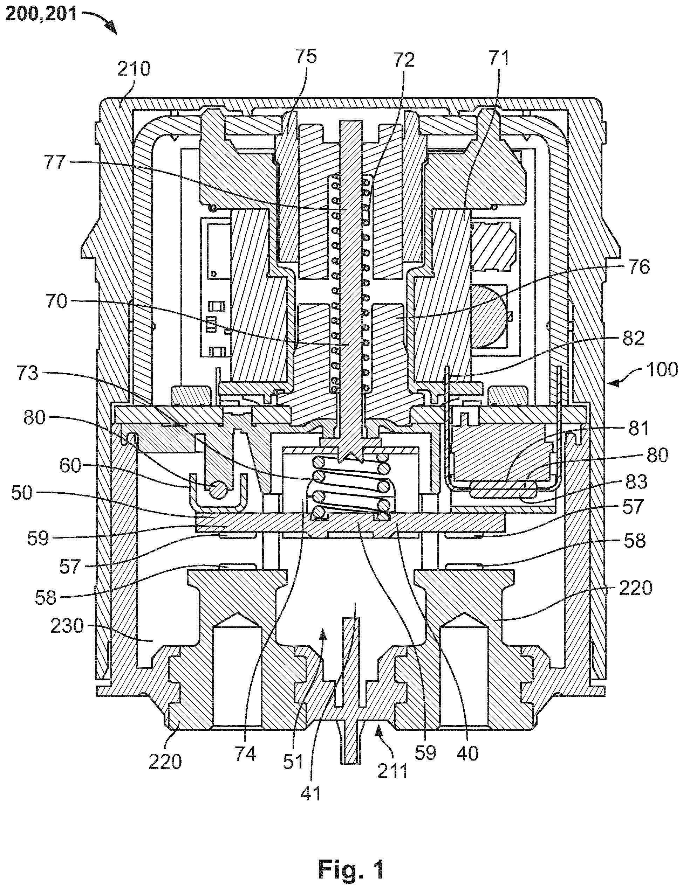

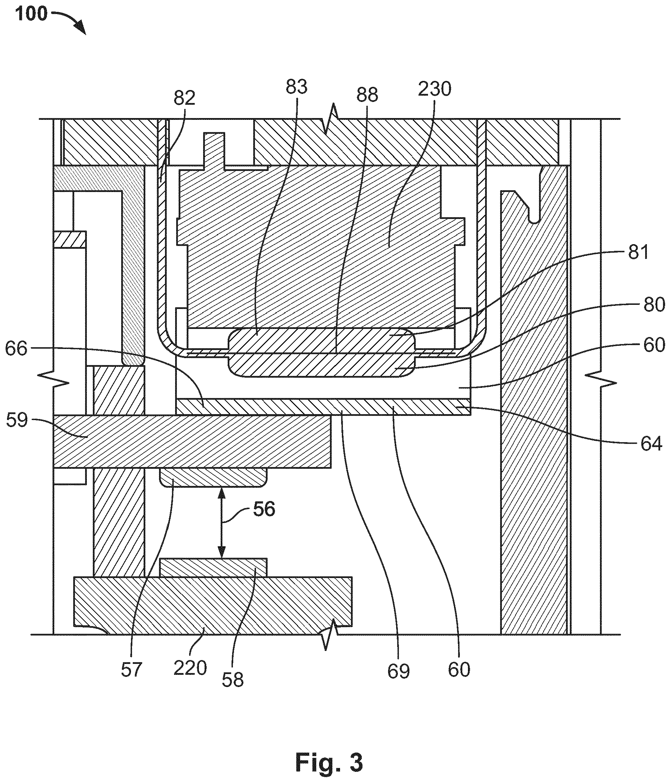

Figures 1 to 3 show an embodiment that has two differently oriented status sensors 80 and associated influencing elements 60. In the configuration shown on the left in Fig. 1 and in Fig. 2, the status sensor 80 and the influencing element 60 extend along the magnetic field lines, whereas in the configuration shown on the right in Fig. 1 and in Fig. 3, their extension direction is perpendicular to the magnetic field lines.

In both cases, the influencing element 60 is configured as an attenuating element 64. It is a metal part 66 cut and formed from a sheet metal, which forms a magnetic shielding 65 for the status sensor 80. In the closed, second switching position not shown, the influencing element 60 is located at a distance from the status sensor 80. In the open switching position 51 shown, on the other hand, the influencing element 60 extends around the status sensor 80. The status sensor 80 is arranged in a receptacle 67 of the influencing element 60, which is formed as a channel 68, however without touching it. Due to the magnetic shielding 65, the magnetic field at the location of the status sensor 80 is weaker in the first switching position 51 than in the second switching position, which is not shown. This allows the status sensor 80 to detect the status of the switch 200.

In other embodiments not shown, the influencing element 60 could also be configured as an amplifying element that amplifies the blow magnetic field 20 at the location of the status sensor 80. For example, a tip or a protrusion could be formed so that the magnetic field is bundled there. If such a tip or protrusion is closer to the status sensor 80, a stronger magnetic field prevails there.

In further configurations, the influencing element 60 may also be configured to change the direction of the magnetic field present at the location of the status sensor and thereby cause a change in an output signal of the status sensor 80.

In the examples shown, the control element 40 is the switching element 50 at the same time. The influencing element 60 is rigidly connected to the control element 40, for example by being welded onto it or glued to it. In a preferred embodiment not shown, the switching element 50 could also be configured so that a part of it acts as an influencing element 60. For example, a protruding tip could be formed.

In other configurations, the control element 40 may not be rigidly connected to the switching element 50. For example, the cage 74 could serve as the control element 40. An influencing element 60 could be attached to it. In this case, the movement of the control element 40 would not correlate 1:1 with the movement of the switching element 50, as the control element 40 can move relative to the same against the spring force of the contact spring 73. Status monitoring is nevertheless possible, as different switching positions of the switch 200 can be associated with different control positions of the control element 40 and the blow magnetic field 20 acting on the status sensor 80 is dependent on a relative position between the status sensor 80 and the influencing element 60, wherein the relative position changes when the control position of the control element 40 changes.

In order to enable simple manufacture, the status sensor 80 is adapted as a single component 88 in each case. In the examples shown, the status sensor 80 is a reed switch 81, in which two conductors (not shown) that can be deflected towards each other by the magnetic field are connected or disconnected in a glass tube 83. External elements can be connected via connection lines 82 and the status can be queried. The reed switch 81 is a discrete switch with discrete output signals, namely one "conductive" and one "non-conductive".

In the first control position 41, the magnetic field at the status sensor 80 is below a switching threshold and in the second control position it is above the switching threshold. A switching point of the status sensor 80 can be selected such that it is before or after the opening and/or before or after the closing of the switch 200.

In the two examples, it is shown that the influencing element 60 moves while the status sensor 80 is fixedly attached to a carrier 212 of the switch 200. A reverse configuration, in which the status sensor 60 moves, or a configuration in which both the influencing element 60 and the status sensor 80 move, are also conceivable.

It is particularly preferred if, in at least one of the control positions 41, the status sensor 80 is surrounded by a magnetic shielding 60 that is closed in a ring-shaped manner around the status sensor 80, as a particularly good magnetic shielding effect is then achieved. The influencing element 60 is thereby advantageously part of the shielding 65. Other parts can be formed, for example, by a housing 210, a base 211 or other elements of the switch.

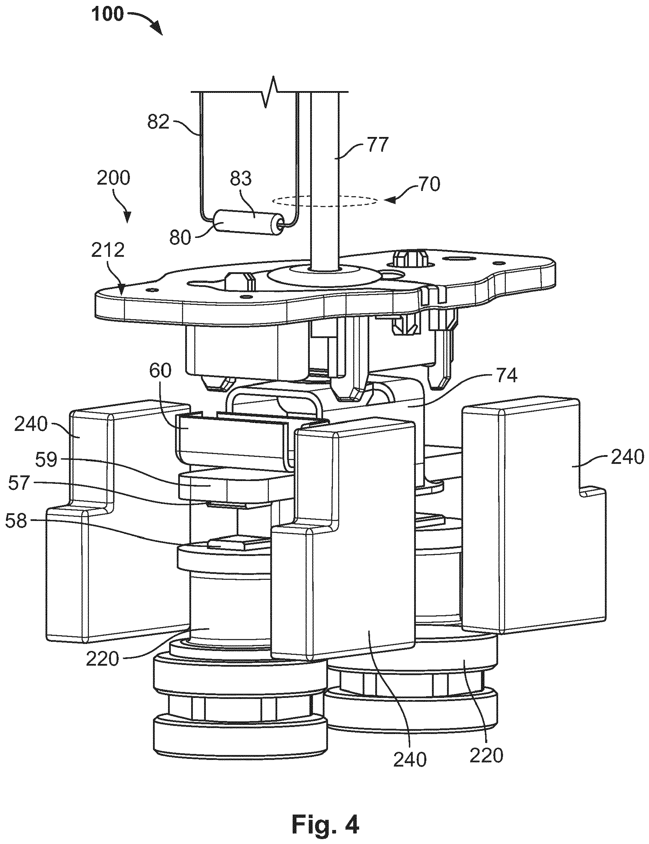

In particular, the status sensor 80 can be located in one of the control positions 41 in a shielding 65 that is closed on all sides. However, such a configuration usually means increased structural effort, so that the configuration of Figures 1 to 4, which is easier to implement, is often preferred.

The influencing elements 60 shown are each one-piece and symmetrical, so that manufacturing and installation are simple.

In the examples shown, the influencing element 60 is configured as a mechanical shielding 69 for the status sensor 80. In particular, the mechanical shielding 69 lies on a direct connecting line between the status sensor 80 and the contacts 57, 58, so that the status sensor 80 is protected from pressure waves and soot emanating from the area between the contacts 57, 58.

As an alternative to the linear movement of the control element 40 and the switching element 50 shown, rotational or mixed movements are also possible.

The connection lines 82 serving as signal conductors can be guided to control or regulating electronics located inside the switch. It is furthermore possible to guide them to the outside so that the corresponding signal can be further processed by elements located outside the housing 210.

In a preferred configuration, one of the connection lines 82 serving as electrical connections is connected to an existing ground or earth potential.

Furthermore, it may be provided that the status sensor 80 is embedded in a magnetically permeable material, for example in a plastic of a contact carrier 220 or a carrier 212.

The solutions shown have the advantage that the assembly 100 does not require an additional magnet. The influencing element 60 rather acts on the already existing blow magnetic field 20. Advantageously, the blow magnetic field 20 is only significantly influenced when a distance 56 between the movable contact element 57 and the fixed contact element 58 has exceeded a certain release value at which it can be safely assumed that the arcs have already been extinguished.

### List of Reference Signs

- 20: blow magnetic field
- 30: contact element
- 40: switching element
- 41: first contact position
- 50: switching element
- 51: first switching position
- 56: distance
- 57: movable contact element
- 58: fix contact element
- 59: contact bridge
- 60: influencing element
- 64: attenuating element
- 65: magnetic shielding
- 66: metal part
- 67: receptacle
- 68: channel
- 69: mechanical shielding
- 70: drive
- 71: coil
- 72: spring
- 73: contact spring
- 74: cage
- 75: first body
- 76: second body
- 77: drive rod
- 80: status sensor
- 81: reed switch
- 82: connection lines
- 83: glass tube
- 88: component
- 100: assembly
- 200: switch
- 201: relay
- 210: housing
- 211: base
- 212: carrier
- 220: contact carrier
- 230: switching chamber
- 240: blow magnets
- 241: magnet conducting elements

## Claims

1. Assembly (100) for monitoring the status of a switch (200) for high currents and/or high voltages with a blow magnetic field (20) and a control element (40) that can be moved into several control positions (41) by a drive (70), wherein different switching positions (51) of the switch (200) are associated with different control positions (41) of the control element (30),
wherein the assembly (100) comprises a status sensor (80) that can be influenced by the blow magnetic field (20) and an influencing element (60) for influencing the blow magnetic field (2) at the status sensor (80),
wherein the blow magnetic field (20) at the status sensor (80) depends on a relative position between the status sensor (80) and the influencing element (60), and wherein the assembly (100) is configured such that the relative position changes when the control position (41) of the control element (30) changes.

2. Assembly (100) according to claim 1, wherein the influencing element (60) is mechanically coupled to the control element (30).

3. Assembly (100) according to claim 1 or 2, wherein the control element (30) and the influencing element (60) are rigidly connected to each other.

4. Assembly (100) according to any one of claims 1 to 3, wherein the influencing element (60) is an attenuating element (64).

5. Assembly (100) according to any one of claims 1 to 4, wherein in at least one of the control positions (41) the status sensor (80) is surrounded by a magnetic shielding (65) that is closed in a ring-shaped manner around the status sensor (80), wherein the influencing element (60) is part of the shielding (65).

6. Assembly (100) according to any one of claims 1 to 5, wherein the influencing element (60) is an amplifying element.

7. Assembly (100) according to any one of claims 1 to 6, wherein the influencing element (60) is a direction changing element.

8. Assembly (100) according to any one of claims 1 to 7, wherein the influencing element (60) comprises a punched and/or formed metal sheet.

9. Assembly (100) according to any one of claims 1 to 8, wherein the influencing element (60) is a mechanical shielding (69) for the status sensor (80).

10. Assembly (100) according to any one of claims 1 to 9, wherein the status sensor (80) is a discrete status sensor.

11. Assembly (100) according to any one of claims 1 to 10, wherein the status sensor (80) consists of a single component (88).

12. Assembly (100) according to any one of claims 1 to 11, wherein the status sensor (80) is a reed switch (81).

13. Assembly (100) according to any one of claims 1 to 12, wherein the status sensor (80) is arranged within a switching chamber (230).

14. Mechanical switch (200) for high currents and/or high voltages, in particular a relay (200), comprising a control element (40) and an assembly (100) according to any one of claims 1 to 13.

15. Method for monitoring the status of a mechanical switch (100) for high currents and/or high voltages with a blow magnetic field (20), wherein the blow magnetic field (20) acting on a status sensor (80) is changed by a movement of a control element (40).
